# FASCICULE DE BREVET EUROPEEN

(11) **EP 3 559 924 B1**
(45) Date de publication et mention de la délivrance du brevet: **30.12.2020**
(21) Numéro de dépôt: 17825186.4
(22) Date de dépôt: 15.12.2017
(51) Int. Cl.: G08C 17/02, H04B 1/00, H02M 1/00, H01Q 9/04, H01Q 1/46, H04B 1/04

(54) **DISPOSITIF MULTIFRÉQUENCE, DISPOSITIF DE COMMANDE ET/OU DE CONTRÔLE, ÉQUIPEMENT DOMOTIQUE ET SYSTÈME MULTIFRÉQUENCE ASSOCIÉ**
MULTIFREQUENZVORRICHTUNG, STEUERUNGS- UND/ODER ÜBERWACHUNGSVORRICHTUNG, ZUGEHÖRIGES MULTIFREQUENZSYSTEM UND TEIL EINER HEIMAUTOMATISIERUNGSANLAGE
MULTIFREQUENCY DEVICE, CONTROLLING AND/OR MONITORING DEVICE, ASSOCIATED MULTIFREQUENCY SYSTEM AND PIECE OF HOME-AUTOMATION EQUIPMENT

(30) Priorité: 26.12.2016 FR 1663377
(43) Date de publication de la demande: 30.10.2019
(73) Titulaire: Somfy Activites SA, 74300 Cluses (FR)
(72) Inventeur: RAMUS, Michel, 74800 Amancy (FR); ROBIN, Serge, 74570 Thorens-Glieres (FR)
(74) Mandataire: Lavoix
(86) Numéro de dépôt international: PCT/EP2017/083131
(87) Numéro de publication internationale: WO 2018/122012

(56) Documents cités:
- EP-A2- 2 109 226
- EP-A2- 2 246 932
- FR-A1- 3 028 693

## Description

La présente invention concerne le domaine de la transmission radiofréquence, c'est-à-dire de signaux radioélectriques. L'invention concerne plus particulièrement un dispositif multifréquence, un dispositif de commande multifréquence, un équipement domotique et un système radiofréquences associé.

L'invention peut trouver une application dans le domaine de la domotique et plus particulièrement dans celui de la commande et/ou du contrôle à distance par radiofréquences. Elle peut, par exemple, trouver une utilisation dans le domaine du bâtiment, afin de commander et/ou contrôler un ou plusieurs actionneurs configurés pour commander au moins une charge électrique. Cette charge électrique peut être destinée par exemple, au confort thermique, visuel ou lumineux, à la protection solaire, à la fermeture ou à la sécurité d'un bâtiment ou de ses abords.

De tels actionneurs peuvent comprendre un module radiofréquence de réception afin de recevoir des signaux radioélectriques d'instructions de la part d'un dispositif de commande à distance. Suivant une variante de réalisation, ces actionneurs peuvent comprendre un module radiofréquence d'émission/réception afin d'échanger des signaux radioélectriques avec un dispositif de commande à distance. Ces dispositifs de commande à distance peuvent être par exemple, une télécommande, un téléphone intelligent (ou «*smartphone*» selon la terminologie anglo saxonne), un boîtier multiservices (ou «*box*» selon la terminologie anglo saxonne) ou tout autre dispositif équivalent. Il peut s'agir d'un émetteur radiofréquences, nomade ou fixe.

Le module radiofréquence comprend au moins une antenne afin d'augmenter la sensibilité et donc la portée de la transmission entre l'émetteur, respectivement le récepteur, du dispositif de commande à distance et le récepteur, respectivement l'émetteur, du module radiofréquence.

Un tel module radiofréquence peut être tel que décrit dans FR-A-3 028 693.

Dans certains modes de réalisation, l'actionneur est disposé dans une enveloppe métallique, ce qui oblige à déporter l'antenne à l'extérieur de cette enveloppe métallique pour préserver la sensibilité. Cependant cette solution n'est pas très esthétique. De plus, lorsque l'antenne est réalisée sous la forme d'un fil électrique, un installateur voyant un fil non connecté peut être tenté de le couper pensant que ce fil n'est pas utilisé.

Il est connu d'utiliser un conducteur d'un câble d'alimentation secteur d'un module radiofréquence pour former une partie de l'antenne de ce module, soit par un couplage direct, soit par un couplage partiel. Pour des questions de facilité et de sécurité, le conducteur utilisé est généralement le conducteur de neutre. Un problème se pose lorsque l'on souhaite réaliser un dispositif utilisant au moins deux fréquences différentes pour émettre et/ou recevoir des signaux radiofréquences. Dans ce cas de figure, plusieurs antennes sont nécessaires et l'utilisation du câble d'alimentation secteur comme antenne nécessiterait l'emploi d'au moins un conducteur de phase. Du fait de la tension du réseau électrique d'alimentation, à savoir 330V crête ou 170V crête suivant les pays, l'utilisation d'un conducteur de phase connecté au réseau électrique ne serait pas sans risque pour les composants électriques et les utilisateurs.

Un but de l'invention est notamment de corriger tout ou partie des inconvénients précités en proposant un dispositif multifréquence apte à recevoir et/ou émettre des signaux radioélectriques sur plusieurs fréquences différentes et utilisant un câble secteur comme antenne. L'invention a également pour but de fournir un dispositif de commande multifréquence, un équipement domotique et un système radiofréquence associés.

A cet effet, l'invention a pour objet un dispositif multifréquence configuré pour être connecté par au moins un premier et un deuxième conducteurs à un réseau d'alimentation électrique, le dispositif comprenant :
- au moins un module radiofréquence comprenant au moins un premier et un deuxième ports entrée/sortie, le premier port entrée/sortie étant apte à émettre et/ou recevoir des signaux radiofréquences sur une première fréquence, le deuxième port entrée/sortie étant apte à émettre et/ou recevoir des signaux radiofréquences sur une deuxième fréquence distincte de la première fréquence,
- au moins un premier et un deuxième circuits d'accord configurés pour bloquer la propagation de signaux radiofréquences se propageant respectivement sur le premier et le deuxième conducteur, chaque circuit d'accord comprenant une pluralité de bornes,
   - une borne de chaque circuit d'accord étant connectée respectivement au premier conducteur ou au deuxième conducteur,
   - une borne de chaque circuit d'accord étant connectée respectivement au premier port entrée/sortie ou au deuxième port entrée/sortie du module radiofréquence,
- des moyens de découplage configurés pour stopper la propagation de signaux électriques d'alimentation entre les premier et deuxième conducteur et entre au moins un conducteur et un port entrée/sortie du module radiofréquence.

Grâce à l'invention, une réception de signaux radioélectriques est possible sur au moins deux fréquences différentes, alors que le module radiofréquence est protégé contre les remontées de courant provenant du réseau d'alimentation électrique.

Selon des aspects avantageux mais non obligatoires de l'invention, un tel dispositif multifréquence peut incorporer une ou plusieurs des caractéristiques suivantes prises selon toute combinaison techniquement admissible :
- Le premier circuit d'accord comprend au moins trois bornes, une première borne du premier circuit d'accord étant connectée au premier conducteur, une deuxième borne du premier circuit d'accord étant connectée au premier port entrée/sortie du module radiofréquence par l'intermédiaire d'un condensateur de découplage et une troisième borne du premier circuit d'accord du circuit d'accord étant connectée à une masse électrique du dispositif multifréquence par l'intermédiaire d'un condensateur de découplage.
- Le premier circuit d'accord comprend, entre les première et troisième bornes, une inductance montée en parallèle avec un condensateur, la deuxième borne du premier circuit d'accord étant connectée en un point de l'inductance situé entre ses deux extrémités.
- Le premier circuit d'accord comprend, entre les première et troisième bornes, une inductance montée en parallèle avec deux condensateurs montés en série, la deuxième borne du premier circuit d'accord étant connectée à la borne commune aux deux condensateurs.
- Le deuxième circuit d'accord est formé par une ligne de transmission dont la longueur est sensiblement égale au quart de la longueur d'onde associée à la deuxième fréquence, une première borne du deuxième circuit d'accord étant connectée à une première extrémité de la ligne de transmission, au deuxième conducteur et au deuxième port entrée/sortie du module radiofréquence et une deuxième borne du circuit d'accord étant connectée à une deuxième extrémité de la ligne de transmission et à la masse électrique du circuit multifréquence.
- La première extrémité de la ligne de transmission est connectée au deuxième port entrée/sortie du module radiofréquence par l'intermédiaire d'un circuit d'adaptation d'impédance configuré pour adapter l'impédance du deuxième conducteur à une valeur sensiblement égale à l'impédance d'entrée du deuxième port entrée/sortie du module radiofréquence.
- Le premier circuit d'accord est également configuré pour adapter l'impédance du premier conducteur à une valeur sensiblement égale à l'impédance d'entrée du premier port entrée/sortie du module radiofréquence.
- Le premier circuit d'accord comprend une inductance réalisée sous forme de spires imprimées.
- Le module radiofréquence est configuré pour émettre et/ou recevoir des signaux radiofréquences sur une seule fréquence.
- Le module radiofréquence est configuré pour émettre et/ou recevoir des signaux radiofréquences sur au moins deux fréquences.
- Le premier et le deuxième conducteurs, connectés au réseau d'alimentation électrique sont respectivement un conducteur de phase et un conducteur de neutre.
- Un des conducteurs, connectés au réseau d'alimentation électrique, est un conducteur de terre.

L'invention concerne également un dispositif de commande et/ou de contrôle par signaux radiofréquences configuré pour alimenter au moins une charge électrique, le dispositif de commande et/ou de contrôle étant caractérisé en ce qu'il comprend au moins un dispositif multifréquence tel que mentionné ci-dessus et un module de commande et/ou de contrôle.

En outre, l'invention concerne un équipement domotique configuré pour être commandé et/ou régulé par des signaux radiofréquences, l'équipement domotique étant caractérisé en ce qu'il comprend un dispositif de commande et/ou de contrôle par signaux radiofréquences tel que mentionné ci-dessus destiné à commander et/ou contrôler une charge électrique appartenant également à l'équipement domotique.

Enfin, l'invention concerne un système multifréquence comprenant un groupe d'au moins un équipement domotique tel que mentionné ci-dessus et un groupe d'au moins un dispositif de commande et/ou de contrôle à distance, le système multifréquence étant caractérisé en ce que le groupe d'au moins un dispositif de commande et/ou de contrôle à distance comprend un module radiofréquence configuré pour coopérer avec au moins un dispositif multifréquence du groupe d'au moins un équipement domotique, afin de le commander et/ou le contrôler.

D'autres particularités et avantages de la présente invention apparaîtront plus clairement à la lecture de la description ci-après, donnée à titre illustratif et non limitatif, et faite en référence aux dessins annexés, sur lesquels :
- La figure 1 représente un exemple de mode de réalisation d'un dispositif multifréquence selon l'invention ;
- Les figures 2 et 3 représentent des exemples de modes de réalisation d'un circuit d'accord utilisé dans le dispositif de la figure 1 ;
- La figure 4 représente un exemple de mode de réalisation d'un dispositif de commande et/ou de contrôle multifréquence selon l'invention ; et
- La figure 5 représente un exemple de mode de réalisation d'un système multifréquence selon l'invention.

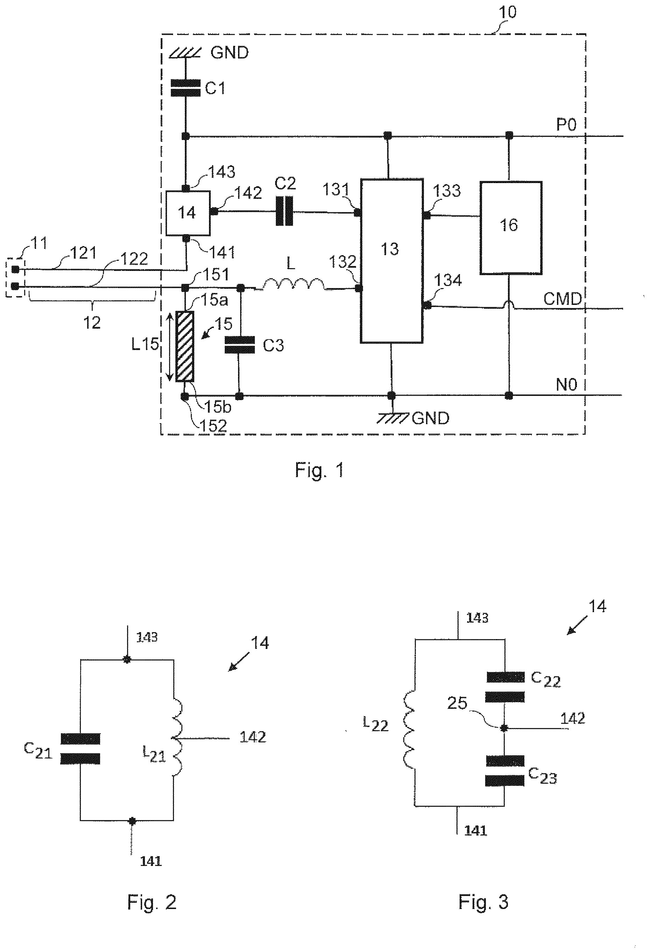

La figure 1 représente un exemple de mode de réalisation d'un dispositif multifréquence 10 selon l'invention.

Le dispositif 10 est configuré pour être connecté à un réseau d'alimentation électrique 11, c'est-à-dire un réseau alternatif commercial, par l'intermédiaire d'un câble secteur 12. Le réseau d'alimentation électrique 11, ou secteur, peut par exemple, être un réseau monophasé ou un réseau électrique triphasé. A titre d'exemple, un réseau électrique monophasé peut délivrer une tension efficace d'amplitude égale à environ 230V ou 120V, avec une fréquence d'environ 50 Hz ou 60Hz. Un réseau électrique triphasé peut délivrer une tension efficace d'amplitude égale à environ 380V ou 230 V entre chacun des conducteurs de phase et une tension efficace d'amplitude égale à environ 120V ou 230 V entre chaque conducteur de phase et le conducteur de neutre.

Le câble secteur 12 comprend un groupe d'au moins deux conducteurs 121, 122. Dans le mode de réalisation illustré sur la figure 1, le câble secteur comprend un conducteur de phase 121 et un conducteur de neutre 122. Suivant une variante de réalisation, le groupe d'au moins deux conducteurs peut comprendre deux ou trois conducteurs de phase. Suivant un autre mode de réalisation, le câble secteur peut comprendre un conducteur de protection relié à la terre. Ces conducteurs peuvent également constituer des premier et deuxième conducteurs, au sens de l'invention.

Chaque conducteur du câble secteur 12 se comporte comme une antenne. Les signaux électriques se propageant sur un ou plusieurs conducteur(s) du câble secteur 12 comprennent donc deux composantes, une première composante basse fréquence (typiquement de fréquence 50 Hz ou 60 Hz) correspondant aux signaux électriques d'alimentation et une composante radiofréquence haute fréquence correspondant aux signaux radioélectriques captés par le câble secteur et se propageant sur les conducteurs de ce dernier.

Le dispositif multifréquence 10 comprend une masse électrique GND.

Le dispositif multifréquence 10 peut être soit de type unidirectionnel c'est à dire purement récepteur ou purement émetteur, soit de type bidirectionnel c'est-à-dire émetteur et récepteur, soit de type mixte. Pour cela il comprend au moins un module radiofréquence 13 apte à émettre et/ou recevoir des signaux radiofréquences sur au moins deux fréquences de valeurs différentes. Le module radiofréquence 13 peut être configuré pour émettre et/ou recevoir des signaux radiofréquences sur une ou plusieurs fréquences, afin d'échanger des signaux radiofréquences avec un autre dispositif d'émission et/ou réception distant. Le module radiofréquence 13 comprend au moins deux ports entrée/sortie 131, 132, un premier port entrée/sortie 131 étant configurée pour au moins recevoir des signaux radiofréquences sur une première fréquence, le deuxième port entrée/sortie 132 étant configuré pour au moins recevoir des signaux radiofréquences sur une deuxième fréquence distincte de la première fréquence. Dans le cas de dispositif multifréquence mixte, une partie des ports entrée/sortie peut être du type unidirectionnel et une autre partie peut être du type bidirectionnel.

Le module radiofréquence comprend une sortie 134 de commande configurée pour transmettre des signaux électriques de commande à une charge non représentée, telle qu'un moteur de volet roulant non représenté.

Suivant un mode de réalisation, le module radiofréquence 13 peut comprendre un port entrée/sortie configurée pour au moins recevoir des signaux comme des signaux électroniques représentatifs d'une ou plusieurs variable d'état. Suivant un mode de réalisation cette entrée/sortie peut être bidirectionnelle et être configurée pour émettre et recevoir des signaux électriques vers et à destination d'un autre dispositif.

Afin de ne pas surcharger la figure, seuls les ports entrée/sortie 131, 132 du module radiofréquence 13 ont été représentés. Le module radiofréquence comprend d'autres éléments connus de l'homme du métier comme un dispositif d'alimentation, un circuit Haute Fréquence amplificateur-démodulateur, un ou plusieurs microcontrôleurs ou processeurs et/ou tous autres moyens équivalents programmés de façon opportune. De ce fait, le module radiofréquences 13 est à même de recevoir et de décoder des signaux représentatifs d'ordres de commande et éventuellement d'émettre des signaux représentatifs d'informations.

Le module radiofréquences 13 comprend une masse électrique connectée à la masse électrique GND du dispositif multifréquence 10.

Le module radiofréquence 13 peut être alimenté à partir de la tension délivrée par le secteur par exemple, par une entrée d'alimentation 133 connectée entre une ligne de phase interne P0 et une ligne de neutre interne N0. Dans ce mode de réalisation non représenté, le module radiofréquence 13 peut comprendre un dispositif d'alimentation interne configuré pour transformer la tension alternative, par exemple d'amplitude sensiblement égale à 230 V et de fréquence 50Hz, délivrée par le réseau électrique 11 en une tension interne, par exemple continue d'amplitude sensiblement égale à 3V, utilisable pour l'alimentation des différents composants électroniques du module radiofréquences 13.

Suivant un autre mode de réalisation représenté à la figure 1, le dispositif multifréquence 10 peut comprendre un dispositif d'alimentation 16 connecté entre une ligne de phase interne P0 et une ligne de neutre interne N0 et destiné à alimenter le module radiofréquence 13 avec une tension inférieure à celle du secteur. Pour cela, l'entrée d'alimentation 133 du module radiofréquence 13 peut être connectée à une sortie d'alimentation 161 du dispositif d'alimentation 16.

Le dispositif multifréquence comprend un premier circuit d'accord 14 configuré pour limiter la propagation de signaux radiofréquences sur le conducteur 121, 122 sur lequel il est connecté. En référence aux figures 2 et 3, le circuit d'accord 14 comprend au moins un bobinage et un condensateur connectés en parallèle formant un circuit résonnant ou circuit d'isolation (également connu sous le nom de «circuit-bouchon »). Les bobinage et condensateur du circuit d'accord sont dimensionnés de sorte que le circuit résonnant soit accordé sur une fréquence sensiblement égale à la fréquence des signaux de la porteuse utilisée pour la transmission radiofréquence.

Ce premier circuit d'accord 14 peut également avoir une deuxième fonction d'adaptation d'impédance. Dans ce mode de réalisation, les différents composants de ce circuit 14 sont également dimensionnés de façon à adapter l'impédance du conducteur auquel il est connecté, vue au niveau du premier port entrée/sortie 131 du module radiofréquence 13, à une valeur sensiblement égale à celle de l'impédance d'entrée de ce premier port entrée/sortie 131. La valeur de cette impédance peut par exemple, être égale à 50 Ohms.

Suivant un mode de réalisation, le dispositif multifréquence 10 peut être implanté sur une carte de circuit imprimé (ou PCB pour «*Printed Circuit Board*» selon la terminologie anglo saxonne). La carte de circuit imprimée peut être une carte double face. Une face de la carte peut être entièrement ou partiellement métallisée afin de former un plan de masse.

Suivant un mode de réalisation, le bobinage L21, L22 du circuit d'accord 14 peut être une inductance imprimée. L'inductance L21, L22 peut être réalisée sous forme de spires imprimées.

Le circuit d'accord 14 comprend trois bornes référencées 141, 142, 143. Une première borne 141 du circuit d'accord 14 est connecté au premier conducteur 121 connecté au réseau d'alimentation électrique. Une deuxième borne 142 du circuit d'accord est connectée au premier port entrée/sortie 131 du module radiofréquence 13 par l'intermédiaire d'un condensateur C2 de découplage. Le condensateur C2 de découplage permet de bloquer la propagation des signaux de fréquence inférieure à une fréquence prédéterminée, ou fréquence de coupure, et d'autoriser la propagation des signaux de fréquence supérieure à cette fréquence prédéterminée. De façon avantageuse, la valeur de ce condensateur C2 est donc choisie de façon à bloquer la propagation des signaux électriques d'alimentation basse fréquence c'est-à-dire dont la fréquence est sensiblement égale à celle du réseau électrique d'alimentation par exemple 50Hz ou 60Hz. Pour une tension de 230V, ce condensateur C2 peut avoir, par exemple, une valeur de 68 pF avec une tension de service sensiblement égale à 1000V.

Le circuit d'accord 14 réalise un collecteur de tension pour le port entrée/sortie 131 du module radiofréquence 13 auquel il est connecté et doit être référencé à la masse électrique du dispositif multifréquence 10. Afin de ne pas réaliser un court-circuit entre le deuxième conducteur 122 et la masse électrique GND aux basses fréquences, la troisième borne 143 du circuit d'accord 14 est connectée à la masse électrique GND du dispositif multifréquence 10 par l'intermédiaire d'un condensateur de découplage C1. De façon avantageuse, le condensateur de découplage C1 permet d'éviter la propagation des signaux d'alimentation à la masse électrique. A titre d'exemple, le condensateur C1 peut avoir une valeur de 68pF et une tension de service sensiblement égale à 1000V.

La troisième borne 143 du circuit d'accord 14 est connectée au plus près de la masse électrique GND. La distance entre le point de connexion et le circuit d'accord 14 est inférieure, préférentiellement très inférieure, à un quart de la longueur d'onde associée à la fréquence sur laquelle est accordée le circuit d'accord. Par très inférieure, on entend au moins, dix fois voire cent fois, inférieure.

Suivant un premier mode de réalisation, illustré figure 2, le circuit d'accord 14 comprend un bobinage ou inductance L21 et un condensateur C21 connectés en parallèle. La deuxième borne 142 du circuit d'accord 14 est connectée à l'inductance L21 en un point situé entre les deux extrémités de l'inductance. Dans ce mode de réalisation, l'inductance L21 est fictivement divisée en deux bobinages couplés placés en série, la deuxième borne 142 étant connectée à la borne commune de ces deux bobinages.

La figure 3 représente un deuxième mode de réalisation d'un circuit d'accord comprenant une inductance L22 et deux condensateurs C22, C23. Les deux condensateurs sont connectés en série et la deuxième borne 142 du circuit d'accord 14 est connectée au point commun 25 de ces deux condensateurs.

Le dispositif multifréquence 10 comprend une ligne de transmission 15 dont la longueur L15 est sensiblement égale au quart de la longueur d'onde associée à la deuxième fréquence. Ce type de ligne de transmission 15 est généralement appelée ligne quart d'onde. Une première borne 151 du circuit d'accord 15 est connectée à une première extrémité 15a de la ligne de transmission 15, au deuxième port entrée/sortie 132 du module radiofréquence 13 et au deuxième conducteur 122 du câble secteur 12 connecté au réseau d'alimentation électrique 11. Une deuxième borne 152 du circuit d'accord 15 est connectée à une deuxième extrémité 15b de la ligne de transmission 15 et à la masse électrique GND du dispositif multifréquence 10.

La longueur L15 est mesurée entre les deux extrémités 15a et 15b de la ligne de transmission 15.

Pour les signaux ayant une fréquence sensiblement égale à la deuxième fréquence, la ligne quart d'onde est donc équivalente à un circuit résonant parallèle. Cette ligne quart d'onde forme ainsi un deuxième circuit d'accord pour le dispositif multifréquence. A cette fréquence, la ligne quart d'onde présente donc à sa première extrémité 151 une impédance très élevée, théoriquement infinie, c'est-à-dire un circuit ouvert. Pour les signaux radioélectriques de fréquence sensiblement égale à cette fréquence et circulant sur le deuxième conducteur 122, la propagation se fait donc directement vers le deuxième port entrée/sortie 132 du module radiofréquence 13.

Aux basses fréquences, typiquement pour les signaux électriques d'alimentation, la ligne de transmission 15 permet une liaison électrique entre le premier conducteur 121 et la masse électrique GND du dispositif multifréquence 10.

La ligne de transmission 15 forme donc un circuit d'accord pour les signaux se propageant sur le deuxième conducteur 122. Dans ce mode de réalisation, la première borne 151 de ce circuit d'accord 15 est connectée à la fois à la première extrémité 15a de la ligne de transmission 15, au conducteur 122 et au port entrée/sortie 132.

En pratique, la borne 151 et l'extrémité 15a peuvent être confondues, de même que la borne 152 et l'extrémité 15b.

Suivant un mode de réalisation, le dispositif multifréquence 10 peut comprendre une inductance L connectée en série entre le deuxième port entrée/sortie 132 du module radiofréquence 13 et la première extrémité 151 de la ligne de transmission 15. Le dispositif multifréquence 10 peut également comprendre un condensateur C3 connecté entre le deuxième conducteur 122 et la masse électrique GND. De façon avantageuse, l'inductance L et le condensateur C3 permettent une adaptation d'impédance. La valeur de l'inductance L et celle du condensateur C3 sont choisies de façon à adapter l'impédance du deuxième conducteur 122, vue au niveau du deuxième port entrée/sortie 132 du module radiofréquence 13, à une valeur sensiblement égale à celle de l'impédance d'entrée de ce deuxième port entrée/sortie 132. La valeur de cette impédance peut par exemple, être égale à 50 Ohms. A titre illustratif, l'inductance L peut avoir une valeur de 1nH et le condensateur C3 une valeur de 0,7 pF.

De façon analogue, on peut imaginer un dispositif multifréquence 10 configuré pour être connecté à un réseau électrique polyphasé, comme un réseau triphasé, par l'intermédiaire d'un câble secteur 12 comprenant un conducteur de neutre et plusieurs conducteurs de phase. Dans ce cas le dispositif pourra comprendre plusieurs circuits d'accord 14, il comprendra autant de circuit(s) d'accord que de conducteur(s) de phase utilisé(s) pour propager des signaux radiofréquences. De même, le circuit multifréquence pourra comprendre un ou plusieurs modules radiofréquence 13 afin de disposer de suffisamment de port entrée/sortie pour traiter les différents signaux radiofréquences

De façon avantageuse, l'invention permet la réception et/ou l'émission de signaux hertziens radiofréquences entre le milieu aérien et un dispositif multifréquence 10 connecté à un réseau 11 électrique d'alimentation alternatif par l'intermédiaire d'un câble secteur 12 dont au moins deux conducteurs jouent le rôle d'antennes réceptrices et/ou émettrices de longueur indéterminée. Elle permet, pour tout émetteur d'ordres et/ou récepteur d'ordres connecté au secteur, de recevoir ou d'émettre des ordres transmis par ondes hertziennes sous forme aérienne en utilisant comme antenne d'émission et/ou de réception une portion indéterminée de câble secteur 12 au voisinage du point de raccordement au secteur 11.

L'invention est particulièrement intéressante dans une gamme de fréquences supérieures à 100 MHz.

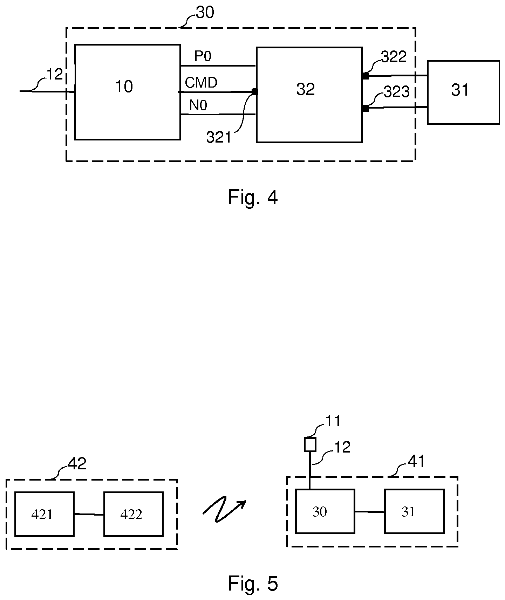

La figure 4 représente un exemple de mode de réalisation d'un dispositif 30 de commande et/ou de contrôle multifréquence, par signaux radiofréquences selon l'invention, configuré pour commander et/ou contrôler une charge électrique 31 à laquelle il est connecté, par exemple un moteur. Le dispositif 30 de commande et/ou de contrôle multifréquence comprend au moins un dispositif multifréquence 10, tel que défini précédemment et un module de commande et/ou de contrôle 32.

Le module de commande et/ou de contrôle 32 peut comprendre un port 321 de commande connectée à la sortie 134 de commande du module radiofréquence 13 par exemple, par l'intermédiaire d'une ligne de commande CMD.

Les ordres de commande générés par le module radiofréquences 13 donnent naissance à des signaux électriques représentatifs de ces ordres de commande. Ces signaux sont ensuite transmis au module de commande et/ou de contrôle 32 par exemple via le port 321 de commande afin d'être traités par le module de commande et/ou de contrôle 32. Après traitement, le module de commande et/ou de contrôle génère des signaux représentatifs d'une commande de la charge électrique qui sont ensuite transmis à cette charge électrique 31. Il peut s'agir, par exemple, d'un moteur dont une sortie entraîne un élément mobile lorsque le moteur est alimenté. Ces signaux peuvent par exemple être disponible sur un port de commande 322 du module de commande et/ou de contrôle 32.

Le module de commande et/ou de contrôle 32 peut comprendre un port de contrôle 323 connectée à une sortie de la charge électrique 31. Ces entrée et sortie sont configurées pour faire transiter des signaux représentatifs de variables d'état afin de contrôler la charge électrique 31 connectée au dispositif 30 de commande et/ou de contrôle multifréquence. En variante, des entrées et sorties sont configurées pour faire transiter des signaux représentatifs de variables d'état afin de contrôler plusieurs charges électriques analogues à la charge 31 et connectées au dispositif 30.

Les différents ports de contrôle 321, 323 et le port de commande 322 peuvent être des ports de type unidirectionnel ou bidirectionnel.

Le module de commande et/ou de contrôle 32 peut être réalisé en un module unique configuré pour mettre en œuvre les deux fonctions de commande et de contrôle ou être réalisé en deux modules distincts assurant chacun une fonction de régulation ou de contrôle.

Le module de commande et/ou de contrôle 32 peut être connecté au réseau d'alimentation électrique par une ligne de phase interne P0 et par une ligne de neutre interne N0.

A titre illustratif, dans l'exemple de mode de réalisation de la figure 1, la ligne de phase interne P0 est connectée au conducteur de phase 121 du câble secteur par l'intermédiaire du circuit d'accord 14 et la ligne de neutre interne N0 est connectée au conducteur de neutre 122 du câble secteur par l'intermédiaire de la ligne de transmission 15.

Dans le cas où la charge électrique 31 est un moteur comprenant une première, une deuxième et une troisième bornes moteur, une partie commande du module de commande et/ou de contrôle 32 peut être formée par une unité de commutation simplement constituée de relais permettant de connecter la ligne de phase interne PO et la ligne de neutre interne NO à certaines bornes du moteur. Les trois bornes du moteur peuvent être connectées au port de commande 322 du module de commande et/ou de contrôle 32 par exemple par l'intermédiaire d'un câble comprenant trois conducteurs, chacun des conducteurs étant connecté à une des bornes moteur.

Dans le cas où la charge électrique 31 est un moteur de type à induction monophasé, l'unité de commutation peut être configurée pour permettre la connexion de la ligne de phase interne PO soit à la première borne moteur soit à la deuxième borne moteur, selon le sens de rotation désiré, tout en connectant la troisième borne moteur à la ligne de neutre interne N0.

Dans le cas où la charge électrique 31 est un moteur de type synchrone autopiloté (ou «*brushless*» selon la terminologie anglo saxonne) l'unité de commutation peut comprendre un redresseur suivi par exemple d'un onduleur triphasé dont les trois sorties sont connectées aux trois bornes moteur. Le redresseur peut aussi être dissocié du module de commutation.

Dans le cas où la charge électrique 31 est un moteur de type à courant continu à collecteur, la troisième borne moteur n'existe pas. L'unité de commutation peut comprendre un redresseur dont les deux bornes de sortie sont connectées par relais soit à la première borne moteur et à la deuxième borne moteur, soit en inversant la connexion de ces deux bornes, selon le sens de rotation du moteur désiré.

Lorsque le câble 12 secteur connecté au dispositif de commande et/ou de contrôle est parcouru par un courant, le circuit d'accord 14 est parcouru par un courant I formé d'au moins deux composantes. Une première composante est un courant alternatif basse fréquence, par exemple de fréquence 50 Hz ou 60 Hz, destiné à alimenter la charge électrique 31 connecté au dispositif de commande et de contrôle. Son intensité peut être variable selon le mode d'activité de la charge électrique, notamment lorsque la charge est un moteur. Une deuxième composante est une composante radiofréquence haute fréquence correspondant aux signaux radioélectriques se propageant sur un conducteur 121 du câble 12 auquel est connecté le circuit d'accord 14.

Entre la première borne 141 et la troisième borne 143 du circuit d'accord 14, la composante radiofréquence haute fréquence du courant est bloquée par le circuit résonnant parallèle contenu dans le circuit d'accord 14. De plus, du fait de la connexion du circuit d'accord 14 à la masse électrique GND, la composante radiofréquence haute fréquence prélevée sur le circuit résonnant parallèle au niveau de la deuxième borne 142 n'est pas perturbée par la consommation de la charge électrique 31 connectée, comme par exemple un moteur dont l'intensité est variable selon son mode d'activité.

Des modes de réalisation du circuit d'accord 14 autre que ceux présentés sur les figures 2 et 3 sont possibles dans le cadre de l'invention, pourvu que le circuit d'accord 14 puisse être directement traversé par la composante basse fréquence du courant et qu'il bloque la propagation de la composante radiofréquence haute fréquence au sein du courant destiné à alimenter la charge électrique.

Le dispositif 30 de commande et/ou de contrôle multifréquence est présenté ci-dessus à travers un exemple d'application à la commande et/ou le contrôle d'un moteur. Cet exemple n'est nullement limitatif. Le dispositif 30 peut être associé à d'autres charges électriques, comme un système d'éclairage, un système de régulation de chauffage, un système d'alarme, un système vidéo, etc.

La figure 5, représente un exemple de mode de réalisation d'un système multifréquence 40 selon l'invention. Ce système peut, par exemple, former tout ou partie d'une installation domotique.

Le système 40 comprend un groupe d'au moins un équipement domotique 41 configuré pour être connecté, par un câble secteur 12 comprenant au moins deux conducteurs du type des conducteurs 121, 122 visibles à la figure 1, à un réseau d'alimentation électrique 11 et pour être commandé et/ou régulé par des signaux radiofréquences.

L'équipement domotique 41 peut être un actionneur agencé pour déplacer ou régler un élément d'un bâtiment, par exemple un actionneur pour déplacer un volet roulant ou un store, un système de régulation pour un chauffage ou un système aéraulique. Un équipement domotique peut également être un éclairage, par exemple un éclairage intérieur ou extérieur comme un éclairage de terrasse, un système de commande d'éclairage, un système d'alarme, une caméra vidéo, en particulier une caméra de vidéosurveillance, etc.

L'équipement domotique 41 comprend un dispositif 30 de commande et/ou de contrôle multifréquence tel que décrit précédemment.

Le système 40 comprend également un ou plusieurs dispositifs de commande et/ou de contrôle à distance 42 comportant un module radiofréquence 421 configuré pour coopérer avec au moins un dispositif multifréquence 10 du groupe d'au moins un équipement domotique 41, afin de le commander et/ou le contrôler.

Le dispositif de commande et/ou de contrôle à distance 42 peut être un émetteur d'ordres comprenant par exemple, un clavier de commande 422 et un module radiofréquence 421, comme un émetteur radiofréquences.

Il peut également s'agir d'un capteur, par exemple configuré pour réguler une variable d'état comme une température, une intensité lumineuse, une pression, etc, d'un capteur de détection de présence, de détection météorologique, de qualité de l'air ou d'alarme. Ces différents types de capteur peuvent être assimilés à des dispositifs de commande et/ou de contrôle à distance 42, même s'ils ne transmettent que des signaux représentatifs de données de mesures.

Le module radiofréquence 421 peut être un module unidirectionnel configuré pour seulement émettre, un module bidirectionnel configuré pour émettre et recevoir des signaux radiofréquences ou un module mixte comprenant par exemple plusieurs canaux, certains canaux étant configurés pour seulement émettre des signaux radiofréquence et d'autres canaux étant configurés pour à la fois émettre et recevoir des signaux radiofréquences.

En référence à la figure 5, le dispositif de commande et/ou de contrôle à distance 42 communique par l'intermédiaire de signaux radiofréquences avec un équipement domotique 41. Il peut s'agir d'un actionneur comprenant un moteur.

Le clavier de commande 422 du dispositif de commande et/ou de contrôle à distance 42 comprend des touches de commande. Selon la touche activée, le module radiofréquence 421 émet des signaux radiofréquences représentatifs d'un ordre de de commande, par exemple un ordre de mouvement dans une première direction, un ordre de mouvement dans une deuxième direction, un ordre d'arrêt. Le dispositif de commande et/ou de contrôle 30 de l'équipement domotique 41 reçoit les signaux représentatifs des ordres émis par le dispositif de commande et/ou de contrôle à distance 42 et les transforme s'il y lieu en ordres de commande du moteur de l'actionneur de la charge électrique 31.

La sortie de l'actionneur est connectée à un élément mobile pouvant se déplacer selon plusieurs directions selon la commande appliquée au moteur. L'élément mobile peut être installé dans un bâtiment ou à ses abords et se déplacer dans un espace du bâtiment, par exemple devant une baie, sur une terrasse, etc. Il peut d'agir par exemple d'un volet roulant, d'un store, d'une porte de garage, d'un portail...

Les équipements domotiques 41 et les dispositifs de commande et/ou de contrôle à distance 42 peuvent être du type monodirectionnel, c'est-à-dire assurant seulement la fonction de réception ou assurant seulement la fonction d'émission ou du type bidirectionnel c'est-à-dire assurant les deux fonctions d'émission et de réception.

A titre d'exemple, un dispositif de commande et/ou de contrôle à distance 42 peut émettre des signaux radiofréquences représentatifs d'une commande, par exemple la levée de stores. A la réception, le dispositif 30 de commande et/ou de contrôle multifréquence traite ces signaux radiofréquences et délivre des signaux de commande en direction de la charge électrique 31 connectée afin d'exécuter la commande demandée. En retour, le dispositif 30 de commande et/ou de contrôle multifréquence peut émettre des signaux radiofréquences en direction du dispositif de commande et/ou de contrôle à distance 42. Ces signaux peuvent par exemple être des signaux représentatifs d'un «accusée de réception» afin de confirmer la bonne réception de la commande. Il peut également s'agir de signaux représentatifs d'un message confirmant la bonne exécution de la commande, par exemple lorsque le store est levé.

Différents exemples d'utilisations du dispositif multifréquence 10 et du dispositif de commande et/ou de contrôle 30 par signaux radiofréquences sont présentés ci-après.

Suivant les pays, les équipements domotiques 41 commandables et/ou contrôlables à distance par l'intermédiaire de signaux radiofréquences ne le fonctionnent pas tous sur la même fréquence. Cela oblige les constructeurs à développer et fabriquer des dispositifs multifréquences et des dispositifs de commande et/ou de contrôle par signaux radiofréquences différents. De façon avantageuse, la présente invention peut permettre de simplifier, par exemple, la conception de ces dispositifs, ainsi que la gestion des stocks.

Comme énoncé précédemment, de part sa conception, le module radiofréquence 13 est apte à émettre et/ou recevoir des signaux radiofréquences sur plusieurs fréquences de valeurs différentes, par exemple sur un nombre entier n de fréquences avec n supérieur ou égal à deux. Suivant un premier mode d'utilisation du dispositif 30 de commande et/ou de contrôle par signaux radiofréquences, le module radiofréquence 13 peut être configuré pour émettre et/ou recevoir des signaux radiofréquences sur un nombre de fréquences strictement inférieur à n.

A titre d'exemple nullement limitatif, le module radiofréquence 13 peut être un module bifréquence apte à recevoir ou émettre et recevoir des signaux radiofréquences sur les fréquences de 868 MHz et 2,4 GHz. Avant d'être monté dans un équipement domotique 41, le module radiofréquence 13 peut être configuré pour ne fonctionner que sur une seule de ces deux fréquences correspondant à une fréquence utilisée dans le ou les pays de destination. Cette configuration peut par exemple être réalisée lors de la programmation du module radiofréquence 13. Ces valeurs de fréquences ne sont nullement limitatives et d'autre fréquences peuvent être utilisées comme par exemple la fréquence de 433 MHz.

Ainsi, le constructeur n'est plus obligé de concevoir autant de dispositifs multifréquences que de fréquences d'utilisation, un seul dispositif permettant de couvrir toutes les fréquences possibles. De même, une même chaine de montage permet de monter tous les équipements domotiques, quel que soit le pays de destination.

Suivant une variante d'utilisation du dispositif 30 de commande et/ou de contrôle par signaux radiofréquences selon l'invention, le module radiofréquence 13 peut être configuré pour émettre et/ou recevoir des signaux radiofréquences sur n fréquences, avec un entier n supérieur ou égal à deux. Un équipement domotique peut, par exemple être configuré pour être commandable à partir de deux types de signaux radiofréquences de fréquences différentes. Il peut s'agir par exemple d'un actionneur de portail, de porte de garage, de volet roulant commandable par un dispositif de commande à distance comme une télécommande émettant sur une première fréquence ou une application de téléphone portable télécommande émettant sur cette première fréquence. En cas de fortes perturbations électromagnétiques autour de cette première fréquence, la télécommande peut avoir du mal à commander l'actionneur. Ce peut être le cas avec la fréquence de 2,4 GHz qui est également utilisée pour d'autres applications comme par exemple le Wi-Fi. Dans ce cas, l'utilisateur peut utiliser un deuxième dispositif de commande à distance, comme une deuxième télécommande, émettant sur une deuxième fréquence ou un autre canal du même dispositif de commande à distance, s'il est multifréquence. Le dispositif 30 de commande et/ou de contrôle peut donc être piloté sur deux fréquences distinctes, en fonction des besoins.

Ce dispositif 40 de commande multifréquence peut également trouver une utilité dans le cas où la portée du dispositif de commande à distance devient insuffisante pour commander un équipement domotique à distance sur une première fréquence. Dans ce cas, l'utilisateur peut utiliser un autre dispositif de commande à distance ou un autre canal fonctionnant sur une deuxième fréquence de portée supérieure du même dispositif de commande à distance.

Un tel dispositif 30 de commande et/ou de contrôle multifréquence peut être utilisé dans un équipement domotique 41, une première fréquence étant utilisée pour commander l'équipement domotique à distance et une deuxième fréquence étant utilisé pour contrôler l'équipement à distance. Pour ce faire, le module radiofréquence 13 peut comprendre un premier port entrée/sortie fonctionnant seulement en réception ou en émission/réception afin d'assurer la fonction commande à distance et un deuxième port entrée/sortie du type bidirectionnel pour réguler l'équipement domotique 41 dans lequel est monté le dispositif 30.

Suivant un autre mode d'utilisation, un équipement domotique 41 dans lequel un dispositif 30 de commande et/ou de contrôle multifréquence est installé peut communiquer sur plusieurs fréquences pour des besoins de redondance et/ou de sécurité. Un tel mode d'utilisation peut par exemple trouver son utilité dans un système d'alarme multifréquence connecté au réseau électrique.

Les différents modes de réalisation et variantes définis ci-dessus non incompatibles peuvent être combinés pour générer de nouveaux modes de réalisation de l'invention, dans le cadre des revendications ci-annexées.

## Revendications

1. Dispositif multifréquence (10) configuré pour être connecté par au moins un premier et un deuxième conducteurs (121, 122) à un réseau d'alimentation électrique (11), le dispositif (10) comprenant au moins un module radiofréquence (13) comprenant au moins un premier port entrée/sortie (131) apte à émettre et/ou recevoir des signaux radiofréquences sur une première fréquence, **caractérisé**
**en ce que** le module radiofréquence (13) comprend au moins un deuxième port entrée/sortie (132) apte à émettre et/ou recevoir des signaux radiofréquences sur une deuxième fréquence distincte de la première fréquence et
**en ce que** le dispositif (10) comprend :
- au moins un premier et un deuxième circuits d'accord (14, 15) configurés pour bloquer la propagation de signaux radiofréquences se propageant respectivement sur le premier et le deuxième conducteur (121, 122), chaque circuit d'accord comprenant une pluralité de bornes,
- une borne (141, 151) de chaque circuit d'accord étant connectée respectivement au premier conducteur (121) ou au deuxième conducteur (122),
- une borne (142, 151) de chaque circuit d'accord étant connectée respectivement au premier port entrée/sortie (131) ou au deuxième port entrée/sortie (132) du module radiofréquence (13),
- des moyens de découplage (C1, C2) configurés pour stopper la propagation de signaux électriques d'alimentation entre les premier et deuxième conducteur (121, 122) et entre au moins un conducteur (121, 122) et un port entrée/sortie (131, 132) du module radiofréquence (13).

2. Dispositif (10) selon la revendication précédente dans lequel le premier circuit d'accord (14) comprend au moins trois bornes (141, 142, 143), une première borne (141) du premier circuit d'accord étant connectée au premier conducteur (121), une deuxième borne (142) du premier circuit d'accord étant connectée au premier port entrée/sortie (131) du module radiofréquence (13) par l'intermédiaire d'un condensateur de découplage (C2) et une troisième borne (143) du premier circuit d'accord du circuit d'accord (14) étant connectée à une masse électrique (GND) du dispositif multifréquence (10) par l'intermédiaire d'un condensateur de découplage (C1).

3. Dispositif (10) selon la revendication 2 dans lequel le premier circuit d'accord (14) comprend, entre les première et troisième bornes (141, 143), une inductance (L21) montée en parallèle avec un condensateur (C21), la deuxième borne (142) du premier circuit d'accord (14) étant connectée en un point de l'inductance (L21) situé entre ses deux extrémités.

4. Dispositif (10) selon la revendication 2 dans lequel le premier circuit d'accord (14) comprend, entre les première et troisième bornes (141, 143), une inductance (L22) montée en parallèle avec deux condensateurs (C22, C23) montés en série, la deuxième borne (142) du premier circuit d'accord (14) étant connectée à la borne commune aux deux condensateurs (C22, C23).

5. Dispositif (10) selon une des revendications précédentes dans lequel le deuxième circuit d'accord est formé par une ligne de transmission (15) dont la longueur (L15) est sensiblement égale au quart de la longueur d'onde associée à la deuxième fréquence, une première borne (151) du deuxième circuit étant connectée à une première extrémité (15a) de la ligne de transmission (15) au deuxième conducteur (122) et au deuxième port entrée/sortie (132) du module radiofréquence (13) alors qu'une deuxième borne (152) du circuit d'accord est connectée à une deuxième extrémité (15b) de la ligne de transmission (15) et à la masse électrique (GND) du circuit multifréquence (10).

6. Dispositif (10) selon la revendication précédente dans lequel la première extrémité (15a) de la ligne de transmission (15) est connectée au deuxième port entrée/sortie (132) du module radiofréquence (13) par l'intermédiaire d'un circuit (L, C3) d'adaptation d'impédance configuré pour adapter l'impédance du deuxième conducteur (122) à une valeur sensiblement égale à l'impédance d'entrée du deuxième port entrée/sortie (132) du module radiofréquence (13).

7. Dispositif (10) selon l'une des revendications précédentes dans lequel le premier circuit d'accord (14) est également configuré pour adapter l'impédance du premier conducteur (121) à une valeur sensiblement égale à l'impédance d'entrée du premier port entrée/sortie (131) du module radiofréquence (13).

8. Dispositif (10) selon une des revendications précédentes dans lequel le premier circuit d'accord (14) comprend une inductance (L21, L22) réalisée sous forme de spires imprimées.

9. Dispositif (10) selon une des revendications précédentes dans lequel le module radiofréquence (13) est configuré pour émettre et/ou recevoir des signaux radiofréquences sur une seule fréquence.

10. Dispositif (10) selon une des revendications 1 à 8 dans lequel le module radiofréquence (13) est configuré pour émettre et/ou recevoir des signaux radiofréquences sur au moins deux fréquences.

11. Dispositif (10) selon une des revendications précédentes dans lequel le premier et le deuxième conducteurs (121, 122), connectés au réseau d'alimentation électrique (11) sont respectivement un conducteur de phase et un conducteur de neutre.

12. Dispositif (10) selon une des revendications précédentes dans lequel un des conducteurs, connectés au réseau d'alimentation électrique, est un conducteur de terre.

13. Dispositif (30) de commande et/ou de contrôle par signaux radiofréquences configuré pour alimenter au moins une charge électrique (31), le dispositif (30) de commande et/ou de contrôle étant **caractérisé en ce qu'**il comprend au moins un dispositif multifréquence (10) selon une des revendications précédentes et un module (32) de commande et/ou de contrôle.

14. Equipement domotique (41) configuré pour être commandé et/ou régulé par des signaux radiofréquences, l'équipement domotique (41) étant **caractérisé en ce qu'**il comprend un dispositif (30) de commande et/ou de contrôle par signaux radiofréquences selon la revendication précédente destiné à commander et/ou contrôler une charge électrique (31) appartenant également à l'équipement domotique.

15. Système multifréquence (40) comprenant un groupe d'au moins un équipement domotique (41) selon la revendication précédente et un groupe d'au moins un dispositif (42) de commande et/ou de contrôle à distance, le système multifréquence (40) étant **caractérisé en ce que** le groupe d'au moins un dispositif (42) de commande et/ou de contrôle à distance comprend un module radiofréquence (421) configuré pour coopérer avec au moins un dispositif (10) multifréquence du groupe d'au moins un équipement domotique (41), afin de le commander et/ou le contrôler.

## Patentansprüche

1. Multifrequenzvorrichtung (10), dazu ausgebildet, über wenigstens einen ersten und einen zweiten Leiter (121, 122) an ein elektrisches Versorgungsnetz (11) angeschlossen zu sein, wobei die Vorrichtung (10) wenigstens ein Radiofrequenzmodul (13) umfasst, das wenigstens einen ersten Eingangs-/Ausgangsport (131) umfasst, der dazu vorgesehen ist, Radiofrequenzsignale auf einer ersten Frequenz zu senden und/oder zu empfangen, **dadurch gekennzeichnet, dass** das Radiofrequenzmodul (13) wenigstens einen zweiten Eingangs-/Ausgangsport (132) umfasst, der dazu vorgesehen ist, Radiofrequenzsignale auf einer zweiten Frequenz zu senden und/oder zu empfangen, die von der ersten Frequenz verschieden ist,
dadurch, dass die Vorrichtung (10) umfasst:
- wenigstens eine erste und eine zweite Abstimmungsschaltung (14, 15), die ausgebildet sind, die Ausbreitung von Radiofrequenzsignalen zu blockieren, die sich jeweils über den ersten und den zweiten Leiter (121, 122) ausbreiten, wobei jede Abstimmungsschaltung eine Mehrzahl von Klemmen umfasst,
- wobei eine Klemme (141, 151) jeder Abstimmungsschaltung jeweils an den ersten Leiter (121) oder an den zweiten Leiter (122) angeschlossen ist,
- wobei eine Klemme (142, 151) jeder Abstimmungsschaltung jeweils an den ersten Eingangs-/Ausgangsport (131) oder an den zweiten Eingangs-/Ausgangsport (132) des Radiofrequenzmoduls (13) angeschlossen ist,
- Entkopplungsmittel (C1, C2), die ausgebildet sind, die Ausbreitung von elektrischen Versorgungssignalen zwischen dem ersten und zweiten Leiter (121, 122) und zwischen wenigstens einem Leiter (121, 122) und einem Eingangs-/Ausgangsport (131, 132) des Radiofrequenzmoduls (13) zu stoppen.

2. Vorrichtung (10) nach dem vorhergehenden Anspruch, wobei die erste Abstimmungsschaltung (14) wenigstens drei Klemmen (141, 142, 143) umfasst, wobei eine erste Klemme (141) der ersten Abstimmungsschaltung an den ersten Leiter (121) angeschlossen ist, wobei eine zweite Klemme (142) der ersten Abstimmungsschaltung an den ersten Eingangs-/Ausgangsport (131) des Radiofrequenzmoduls (13) mittels eines Entkopplungskondensators (C2) angeschlossen ist, und wobei eine dritte Klemme (143) der ersten Abstimmungsschaltung (14) an eine elektrische Masse (GND) der Multifrequenzvorrichtung (10) mittels eines Entkopplungskondensators (C1) angeschlossen ist.

3. Vorrichtung (10) nach Anspruch 2, wobei die erste Abstimmungsschaltung (14), zwischen der ersten und dritten Klemme (141, 143), eine Induktivität (L21) umfasst, die mit einem Kondensator (C21) parallel geschaltet ist, wobei die zweite Klemme (142) der ersten Abstimmungsschaltung (14) in einem Induktivitätspunkt (L21) angeschlossen ist, der zwischen dessen zwei Enden liegt.

4. Vorrichtung (10) nach Anspruch 2, wobei die erste Abstimmungsschaltung (14), zwischen der ersten und dritten Klemme (141, 143), eine Induktivität (L22) umfasst, die mit zwei Kondensatoren (C22, C23), die in Reihe geschaltet sind, parallel geschaltet ist, wobei die zweite Klemme (142) der ersten Abstimmungsschaltung (14) an eine den zwei Kondensatoren (C22, C23) gemeinsame Klemme angeschlossen ist.

5. Vorrichtung (10) nach einem der vorhergehenden Ansprüche, wobei die zweite Abstimmungsschaltung von einer Übertragungsleitung (15) gebildet ist, deren Länge (L15) im Wesentlichen gleich einem Viertel der Wellenlänge ist, die der zweiten Frequenz zugeordnet ist, wobei eine erste Klemme (151) der zweiten Schaltung an einem ersten Ende (15a) der Übertragungsleitung (15), an den zweiten Leiter (122) und an den zweiten Eingangs-/Ausgangsport (132) des Radiofrequenzmoduls (13) angeschlossen ist, während eine zweite Klemme (152) der Abstimmungsschaltung an ein zweites Ende (15b) der Übertragungsleitung (15) und an die elektrische Masse (GND) der Multifrequenzvorrichtung (10) angeschlossen ist.

6. Vorrichtung (10) nach dem vorhergehenden Anspruch, wobei das erste Ende (15a) der Übertragungsleitung (15) an den zweiten Eingangs-/Ausgangsport (132) des Radiofrequenzmoduls (13) mittels einer Impedanzanpassungsschaltung (L, C3) angeschlossen ist, die für die Anpassung der Impedanz des zweiten Leiters (122) an einen Wert ausgebildet ist, der im Wesentlichen gleich der Eingangsimpedanz des zweiten Eingangs-/Ausgangsports (132) des Radiofrequenzmoduls (13) ist.

7. Vorrichtung (10) nach einem der vorhergehenden Ansprüche, wobei die erste Abstimmungsschaltung (14) ebenfalls für die Anpassung der Impedanz des ersten Leiters (121) an einen Wert ausgebildet ist, der im Wesentlichen gleich der Eingangsimpedanz des ersten Eingangs-/Ausgangsports (131) des Radiofrequenzmoduls (13) ist.

8. Vorrichtung (10) nach einem der vorhergehenden Ansprüche, wobei die erste Abstimmungsschaltung (14) eine Induktivität (L21, L22) umfasst, die in Form von gedruckten Windungen ausgebildet ist.

9. Vorrichtung (10) nach einem der vorhergehenden Ansprüche, wobei das Radiofrequenzmodul (13) ausgebildet ist, Radiofrequenzsignale auf einer einzigen Frequenz zu senden und/oder zu empfangen.

10. Vorrichtung (10) nach einem der Ansprüche 1 bis 8, wobei das Radiofrequenzmodul (13) ausgebildet ist, Radiofrequenzsignale auf wenigstens zwei Frequenzen zu senden und/oder zu empfangen.

11. Vorrichtung (10) nach einem der vorhergehenden Ansprüche, wobei der erste und der zweite Leiter (121, 122), die an das elektrische Versorgungsnetz (11) angeschlossen sind, entsprechend ein Phasenleiter und ein Nullleiter sind.

12. Vorrichtung (10) nach einem der vorhergehenden Ansprüche, wobei einer der Leiter, die an das elektrische Versorgungsnetz angeschlossen sind, ein Erdleiter ist.

13. Vorrichtung (30) zur Steuerung und/oder zur Überwachung von Radiofrequenzsignalen, die für die Versorgung wenigstens einer elektrischen Last (31) ausgebildet ist, wobei die Vorrichtung (30) zur Steuerung und/oder Überwachung **dadurch gekennzeichnet ist, dass** sie wenigstens eine Multifrequenzvorrichtung (10) nach einem der vorhergehenden Ansprüche und ein Steuerungs- und/oder Überwachungsmodul (32) umfasst.

14. Haushaltsgerät (41), das ausgebildet ist, über Radiofrequenzsignale gesteuert und/oder geregelt zu werden, wobei das Haushaltsgerät (41) **dadurch gekennzeichnet ist, dass** es eine Vorrichtung (30) zur Steuerung und/oder zur Überwachung von Radiofrequenzsignalen nach dem vorhergehenden Anspruch umfasst, die zum Steuern und/oder Überwachen einer elektrischen Last (31), die ebenfalls dem Haushaltsgerät zugehörig ist, bestimmt ist.

15. Multifrequenzsystem (40), umfassend eine Gruppe aus wenigstens einem Haushaltsgerät (41) nach dem vorhergehenden Anspruch und eine Gruppe aus wenigstens einer Vorrichtung (42) zur Fernsteuerung und/oder Fernüberwachung, wobei das Multifrequenzsystem (40) **dadurch gekennzeichnet ist, dass** die Gruppe aus wenigstens einer Vorrichtung (42) zur Fernsteuerung und/oder Fernüberwachung ein Radiofrequenzmodul (421) umfasst, das für das Zusammenwirken mit wenigstens einer Multifrequenzvorrichtung (10) der Gruppe aus wenigstens einem Haushaltsgerät (41) ausgebildet ist, um sie zu steuern und/oder zu überwachen.

## Claims

1. Multifrequency device (10) designed to be connected by at least first and second conductors (121, 122) to a power supply network (11), the device (10) i comprising :
- at least one radio frequency module (13) comprising at least a first input/output port (131) able to transmit and/or receive radio frequency signals at a first frequency,
**characterized**
**in that** the radio frequency module (13) comprises at least a second input/output port (132) able to transmit and/or receive radio frequency signals on a second frequency that is distinct from the first frequency et
**in that** the device comprises
- at least first and second tuning circuits (14, 15) designed to block the propagation of radio frequency signals being propagated respectively on the first and second conductors (121, 122), wherein each tuning circuit comprises a plurality of terminals:
o wherein a terminal (141, 151) of each tuning circuit is respectively connected to the first conductor (121) or to the second conductor (122),
o wherein a terminal (142, 151) of each tuning circuit is respectively connected to the first input/output port (131), or to the second input/output port (132) of the radio frequency module (13),
- decoupling means (C1, C2) designed to stop the propagation of electrical supply signals between the first and second conductors (121, 122) and between at least one conductor (121, 122) and an input/output port (131, 132) of the radio frequency module (13).

2. Device (10) according to the preceding claim wherein the first tuning circuit (14) comprises at least three terminals (141, 142, 143), wherein a first terminal (141) of the first tuning circuit is connected to the first conductor (121), a second terminal (142) of the first tuning circuit is connected to the first input/output port (131) of the radio frequency module (13) via a decoupling capacitor (C2), and a third terminal (143) of the first tuning circuit of the tuning circuit (14) is connected to an electrical ground (GND) of the multifrequency device (10) via a decoupling capacitor (C1).

3. Device (10) according to claim 2 wherein the first tuning circuit (14) comprises, between the first and third terminals (141, 143), an inductance (L21) connected in parallel with a capacitor (C21), while the second terminal (142) of the first tuning circuit (14) is connected at a point of the inductance (L21) between its two ends.

4. Device (10) according to claim 2 wherein the first tuning circuit (14) comprises, between the first and third terminals (141, 143), an inductance (L22) connected in parallel with two capacitors (C22, C23) connected in series, while the second terminal (142) of the first tuning circuit (14) is connected to the common terminal of the two capacitors (C22, C23).

5. Device (10) according to one of the preceding claims wherein the second tuning circuit is formed by a transmission line (15) whose length (L15) is substantially equal to one quarter of the wavelength associated with the second frequency, wherein a first terminal (151) of the second circuit is connected at a first end (15a) of the transmission line (15) to the second conductor (122) and the second input/output port (132) of the radio frequency module (13), while a second terminal (152) of the tuning circuit is connected to a second end (15b) of the transmission line (15) and to the electrical ground (GND) of the multifrequency circuit (10).

6. Device (10) according to the preceding claim wherein the first end (15a) of the transmission line (15) is connected to the second input/output port (132) of the radio frequency module (13) via an impedance matching circuit (L, C3) designed to match the impedance of the second conductor (122) at a value substantially equal to the input impedance of the second input/output port (132) of the radio frequency module (13).

7. Device (10) according to one of the preceding claims wherein the first tuning circuit (14) is also designed to match the impedance of the first conductor (121) at a value substantially equal to the input impedance of the first input/output port (131) of the radio frequency module (13).

8. Device (10) according to one of the preceding claims wherein the first tuning circuit (14) comprises an inductance (L21, L22) made in the form of printed coils.

9. Device (10) according to one of the preceding claims wherein the radio frequency module (13) is designed to transmit and/or receive radio frequency signals on a single frequency.

10. Device (10) according to one of claims 1 to 8 wherein the radio frequency module (13) is designed to transmit and/or receive radio frequency signals on at least two frequencies.

11. Device (10) according to one of the preceding claims wherein the first and the second conductors (121, 122), connected to the power supply network (11) are respectively a phase conductor and a neutral conductor.

12. Device (10) according to one of the preceding claims wherein one of the conductors, connected to the power supply network, is a ground conductor.

13. Device (30) for control and/or monitoring by radio frequency signals, designed to supply at least one electric load (31), wherein the control and/or monitoring device (30) is **characterized in that** it comprises at least a multifrequency device (10) according to one of the preceding claims, and a module (32) for control and/or monitoring.

14. Home automation equipment (41) designed to be controlled and/or monitored by radio frequency signals, wherein the home automation equipment (41) is **characterized in that** it comprises a device (30) for controlling and/or monitoring radio frequency signals according to the preceding claim for controlling and/or monitoring an electric load (31) also belonging to the home automation equipment.

15. Multifrequency system (40) comprising a group of at least one item of home automation equipment (41) according to the preceding claim and a group of at least one remote controlling and/or monitoring device (42), wherein the multifrequency system (40) is **characterized in that** the group of at least one remote controlling and/or monitoring device (42) comprises a radio frequency module (421) designed to cooperate with at least one multifrequency device (10) of a group of at least one item of home automation equipment (41), in order to control and/or monitor it.
